# EUROPEAN PATENT SPECIFICATION

(11) **EP 2 094 758 B1**
(45) Date of publication and mention of the grant of the patent: **26.01.2011**
(21) Application number: 07850310.9
(22) Date of filing: 03.12.2007
(51) Int. Cl.: C08G 59/40

(54) **CURABLE EPOXY RESIN COMPOSITION, CURED BODY THEREOF, AND USE THEREOF**
HÄRTBARE EPOXIDHARZZUSAMMENSETZUNG, GEHÄRTETER KÖRPER DARAUS UND VERWENDUNG DAVON
COMPOSITION DE RÉSINE ÉPOXY DURCISSABLE, CORPS DURCI DE CETTE COMPOSITION, ET UTILISATION DE CETTE COMPOSITION

(30) Priority: 04.12.2006 JP 2006327219
(43) Date of publication of application: 02.09.2009
(73) Proprietor: Dow Corning Toray Co., Ltd., Tokyo 100-0005 (JP)
(72) Inventor: MORITA, Yoshitsugu, Ichihara-shi Chiba 299-0108 (JP); UEKI, Hiroshi, Ichihara-shi Chiba 299-0108 (JP)
(74) Representative: Gillard, Richard Edward
(86) International application number: PCT/JP2007/073736
(87) International publication number: WO 2008/069333

(56) References cited:
- WO-A-2006/098493
- US-A- 4 877 822
- US-A- 5 561 174

## Description

### Technical Field

The present invention relates to a curable epoxy resin composition, as well as to a cured body of the composition and the use of the composition.

### Background Art

It is known that curable epoxy resin compositions find application as agents for sealing and bonding electrical or electronic devices. However, since cured bodies obtained by curing conventional curable epoxy resin compositions are characterized by a high modulus of elasticity and therefore by high rigidity, the use of such bodies in conjunction with electrical or electronic devices is associated with problems such as development of high stress that occurs under conditions of thermal expansion and shrinkage at curing.
In order to reduce the modulus of elasticity in cured bodies of the aforementioned compositions, it was suggested to combine the curable epoxy resin composition with a diorganopolysiloxane that contains epoxy groups. Such a diorganopolysiloxane, which is disclosed in Japanese Unexamined Patent Application Publication (hereinafter referred to as "Kokai") H06-56999, is one having siloxane residual radicals with epoxy groups on molecular terminals. Kokai H06-56999 does not give specific examples of the contents of the aforementioned curable epoxy resin compositions. However, when the recommended diorganopolysiloxanes are added to the curable epoxy resin compositions, the decrease of modulus of elasticity provided by such an addition in cured bodies may be accompanied by decrease in strength.

On the other hand, it was proposed in Kokai 2006-257115 to replace the curable epoxy resin composition with a curable silicone composition which comprises of a diorganopolysiloxane with silicone residual radicals having epoxy groups on both molecular terminals and a curing agent for an epoxy resins. Although such a curable silicone composition provided a cured body having excellent modulus of elasticity and adhesiveness, the use of this composition was still limited because the cured body was insufficiently strong.

It is an object of the present invention to provide a curable epoxy resin composition that is characterized by excellent moldability, and that, when cured, forms a cured body which, in spite of having a low modulus of elasticity (low stress), has high strength. Another object is to provide a curable epoxy resin composition that is suitable for use as a sealing agent for semiconductor devices. A still further object of the invention is to provide a cured body that combines low modulus of elasticity (low stress) with high strength.

### Disclosure of Invention

The above problems are solved by the present invention that provides a curable epoxy resin composition comprising at least the following components:
(I) an epoxy resin;
(II) a curing agent for an epoxy resin;
(III) a diorganosiloxane that is used in an amount of 0.1 to 100 parts by weight per 100 parts by weight of the sum of components (I) and (II) and is represented by the following general formula:

   A-R²-(R¹₂SiO)ₙ R¹₂Si-R²-A

   {where R¹ designates the same or different unsubstituted or substituted monovalent hydrocarbon groups which are free of unsaturated aliphatic bonds; R² is a bivalent organic group; "A" is a siloxane residual radical represented by the following average unit formula:

   (XR¹₂SiO_{1/2})ₐ (SiO_{4/2})_{b}

   (where R¹ is the same as defined above, and "X" is a single bond, a hydrogen atom, a group designated by R¹, an epoxy-containing monovalent organic group, or an alkoxysilylalkyl group; however, at least one group designated by "X" in one molecule is a single bond, at least two groups designated by "X" are epoxy-containing alkyl groups; "a" is a positive number; "b" is a positive number; and "a/b" is a number ranging from 0.2 to 4), and where "n" is an integer equal to or greater than 1}, and
(IV) an inorganic filler (contained in the composition in an amount of at least 20 wt.%).

The curable epoxy resin composition of the invention is characterized by being used as a sealing agent or an adhesive agent for a semiconductor device.

A cured body of the invention is obtained by curing the composition of the invention.

### Effects of Invention

The curable epoxy resin composition of the invention is efficient in that it possesses excellent moldability, and, when cured, can form a cured body that has high strength in spite of having a low modulus of elasticity (low stress). Furthermore, a cured body of the composition is characterized by high strength along with low modulus of elasticity (low stress).

### Detailed Description of the Invention

The epoxy resin that constitutes component (I) is a main component of the composition. There are no special restrictions with regard to component (I), provided that this component contains an epoxy group such as a glycidyl group or an alicyclic epoxy group. Component (I) may be exemplified by novolak-type epoxy resin, cresol-novolak type epoxy resin, triphenol-alkane type epoxy resin, aralkyl-type epoxy resin, aralkyl-type epoxy resin with a biphenyl backbone, biphenyl-type epoxy resin, dicyclopentadiene-type epoxy resin, heterocyclic-type epoxy resin, naphthalene-ring containing epoxy resin, bisphenol-A type epoxy resin, bisphenol-F type epoxy resin, stilbene-type epoxy resin, trimethylolpropane-type epoxy resin, terpene-modified epoxy resin, linear aliphatic epoxy resin obtained by oxidizing the olefin bond with a peroxy acid, such as a peracetic acid, alicyclic epoxy resin, or sulfur-containing epoxy resin. Component (I) may be composed of one or more of the aforementioned epoxy resins. Most preferable for use as component (I) are aralkyl-type epoxy resin with a biphenyl backbone, biphenyl-type epoxy resin, or a similar epoxy resin that contains a biphenyl group.

Component (I) is generally available. For example, the biphenyl-type epoxy resin is commercially produced by Japan Epoxy Resin Co., Ltd. under the name YX-4000; the bisphenol-F type epoxy resin is commercially produced by Nippon Steel Chemical Co., Ltd. under the name VSLV-80XY; the aralkyl-type epoxy resin with a biphenyl backbone is produced by Nippon Kayaku Co., Ltd. under the names NC-3000 and CER-3000L (a mixture with a phenyl-type epoxy resin); and the naphthol-aralkyl-type epoxy resin is produced by Nippon Steel Chemical Co., Ltd. under the name ESN-175.

When the composition of the invention is used as a sealing agent or an adhesive agent for a semiconductor device, it is recommended that component (I) contain hydrolysable chlorine in an amount of not more than 1000 ppm, preferably not more than 500 ppm. The content of sodium and potassium in component (I) should not exceed 10 ppm of each. If the content of the hydrolysable chlorine exceeds the recommended upper limit, or if the content of sodium and potassium exceed the respective recommended upper limits, this will impair moisture-resistant properties of semiconductor devices having parts sealed or bonded with the use of the composition of the invention when such devices operate under conditions of high temperature and high humidity.

Component (II) is a curing agent for an epoxy resin that reacts with the epoxy groups of component (I) and is used for curing the composition. It is recommended that component (II) be a compound that contains phenolic hydroxyl groups, such as phenol-novolak resin, phenol resin that contains a naphthalene ring, aralkyl-type phenol resin, triphenolalkane-type phenol resin, biphenyl-containing phenol resin, alicyclic phenol resin, heterocyclic phenol resin, bisphenol-A, or bisphenol-F. Component (II) may be composed of two or more of the aforementioned compounds with phenolic hydroxyl groups. The use of component (II) in the form of the biphenyl-containing aralkyl-type phenol resin, or a similar biphenyl-containing phenol resin, is preferable.

Component (II) is readily available. For example, the aralkyl-type phenol resin is commercially produced by Mitsui Chemical Co., Ltd. under the name Milex XLC-3L and by Meiwa Plastic Industries Co., Ltd. under the name MEH-781; the naphthalene-ring-containing phenol resin is produced by Nippon Steel Chemical Co., Ltd. under the names SN-475 and SN-170; the phenol-novolak resin is produced by Meiwa Plastic Industries Co., Ltd. under the name MEH-7500; and the biphenyl-containing phenol resin is produced by Meiwa Plastic Industries Co., Ltd. under the name MEH 7851M.

There are no special restrictions with regard to the amount in which component (II) can be used, provided that this amount is sufficient for curing component (I). However, it is recommended that the epoxy-reactive functional groups of component (II) be in the range of 0.5 to 2.5 moles per 1 mole of the epoxy groups of component (I). For example, when component (II) is a compound that contains phenolic hydroxyl groups, the content of the phenolic hydroxyl groups of component (II) should be in the range of 0.5 to 2.5 moles per 1 mole of the epoxy groups of component (I). If component (II) is contained in an amount less than the recommended lower limit, it will be difficult to provide complete curing of the composition, and, if, on the other hand, the content of component (II) exceeds the recommended upper limit, this will reduce the strength of the cured body.

Component (III) is used in the composition for improving its moldability and for decreasing the modulus of elasticity in the cured body of the composition. Component (III) is a diorganosiloxane of the following general formula:

A-R²-(R¹₂SiO)ₙR¹₂Si-R²-A.

In the above formula, the groups designated by R¹ are same or different and constitute substituted or unsubstituted monovalent hydrocarbon groups without unsaturated aliphatic bonds. Specific examples of such groups are the following: methyl, ethyl, propyl, butyl, pentyl, hexyl, octyl, decyl, octadecyl, or a similar alkyl group; cyclopentyl, cyclohexyl, cycloheptyl, or a similar cycloalkyl group; phenyl, tolyl, xylyl, or a similar aryl groups; benzyl, phenethyl, phenylpropyl, or a similar aralkyl group; and 3-chloropropyl, 3,3,3-trifluoropropyl, or a similar halogenated alkyl group. Most preferable are alkyl groups, especially methyl groups. In the above formula, R² designates bivalent organic groups. These groups can be specifically exemplified by ethylene, methylethylene, propylene, butylene, pentylene, hexylene, or a similar alkylene group; ethylenoxyethylene, ethylenoxypropylene, ethylenoxybutylene, propylenoxypropylene, or a similar alkylenoxyalkylene group. Preferable are alkylene groups, in particular, ethylene groups. In the formula, "n" is an integer, which is equal to or greater than 1 and which represents the degree of polymerization of the diorganosiloxane contained in the main molecular chain. From the viewpoint of improved flexibility of a cured body of the composition, "n" should be equal to or greater than 10. There are no special restrictions with regard to the upper limit of the value of "n", but it is recommended that the value of "n" do not exceed 500.

In the above formula, "A" is a siloxane residual radical represented by the following average unit formula:

(XR¹₂SiO_{1/2})ₐ (SiO_{4/2})_{b}.

In this formula, R¹ designated the same or different substituted or unsubstituted monovalent hydrocarbon groups which are free of unsaturated aliphatic bonds. These groups may be exemplified by the same groups as given for them earlier, most preferable of which are alkyl groups and especially methyl groups. "X" designates a single bond, a hydrogen atom, a group designated by R¹, an epoxy-containing monovalent organic group, or an alkoxysilylalkyl group. However, at least one group designated by "X" in one molecule is a single bond, which is used for bonding to R² in the aforementioned diorganopolysiloxane. Moreover, at least two groups designated by "X" are epoxy-containing alkyl groups.

Groups designated by R¹ may be exemplified by the same groups as mentioned above for R¹. At least one group designated by "X" should be a monovalent hydrocarbon group with 6 or more carbon atoms. In order to improve flowability of the composition, component (III) should be compatible with components (I) and (II). The monovalent hydrocarbon groups may be represented by hexyl, octyl, decyl, octadecyl, or similar alkyl groups; cyclohexyl, cycloheptyl, or similar cycloalkyl groups; and phenyl, tolyl, xylyl, or similar aryl groups; benzyl, phenethyl, phenylpropyl, or similar aralkyl groups, of which alkyl groups are preferable.

The epoxy-containing alkyl groups can be exemplified by 2-glycidoxyethyl, 3-glycidoxypropyl, 4-glicydoxybutyl, or similar glycidoxyalkyl groups; 2-(3,4-epoxycyclohexyl) ethyl, 3-(3,4-epoxychlorohexyl) propyl, or similar 3,4-epoxycyclohexylalkyl groups; and 4-oxiranylbutyl, 8-oxiranyloctyl, or similar oxiranylalkyl groups. Most preferable of these groups are glycidoxyalkyl, especially 3-glycidoxypropyl groups.

The alkoxysilylalkyl groups can be exemplified by trimethoxysilylethyl, trimethoxysilylpropyl, dimethoxymethylsilylpropyl, methoxydimethylsilylpropyl, triethoxysilylethyl, or tripropoxysilylpropyl groups. However, at least one group designated by "X" in one molecule should be an alkoxysilylalkyl, and preferably a trimethoxysilylethyl group.

In the above formula, "a" is a positive number, "b" is a positive number, and "a/b" is a number in the range of 0.2 to 4.

There are no special restrictions with regard to weight-average molecular weight of component (III) but it may be recommended to have this value in the range of 500 to 1,000,000. Also, there are no special restrictions with regard to the form of component (III) at 25°C, but the liquid form is preferable. It is recommended that component (III) have a viscosity at 25°C in the range of 50 to 1,000,000 mPa·s. The method of preparation of component (III) is described, e.g., in Kokai H06-56999.

In the composition of the invention, component (III) is used in an amount of 0.1 to 100 parts by weight, preferably 0.1 to 50 parts by weight, and most preferably 0.1 to 20 parts by weight per 100 parts by weight of the sum of components (I) and (II). If component (III) is used in an amount less than the recommended lower limit, this will increase the modulus of elasticity of a cured body. If, on the other hand, the content of component (III) exceeds the recommended upper limit, this will reduce the strength of the cured body.

Component (IV) is an inorganic filler that is added for strengthening a cured body of the composition. When an inorganic filler is added to a curable epoxy resin composition, this normally improves strength of the body cured from the composition, but at the same time, flowability of the composition is noticeably impaired, and moldability of the composition worsens. Moreover, the modulus of elasticity of the cured body is significantly increased. In contrast to this, joint use of aforementioned components (III) and (IV) protects the composition from loss of flowability and moldability, and, in spite of decrease in modulus of elasticity (low stress), makes it possible to obtain a cured body of high strength.

There are no special restrictions with regard to the filler that constitutes component (IV), and inorganic fillers that are normally admixed with conventional curable epoxy resin compositions can be used for the purposes of the invention. Such fillers can be exemplified by glass fiber, asbestos, alumina fiber, ceramic fiber composed of alumina and silica, boron fiber, zirconia fiber, silicon carbide fiber, metallic fiber, or a similar fibrous filler; amorphous silica, crystalline silica, precipitated silica, fumed silica, baked silica, zinc oxide, baked clay, carbon black, glass beads, talc, calcium carbonate, clay, aluminum hydroxide, magnesium hydroxide, barium sulfate, titanium dioxide, aluminum nitride, boron nitride, silicon carbide, aluminum oxide, magnesium oxide, titanium oxide, beryllium oxide, kaolin, mica, zirconia, or a similar powdery filler. Component (IV) may be composed of two or more such fillers. There are no special restrictions with regard to the shape of the filler particles of component (IV). The powder particles may be spherical, needle-like, plate-like, ground (i.e., irregularly shaped), etc. From the viewpoint of moldability, the spherical shape is preferable. It is also preferable that component (IV) comprise spherical amorphous silica. There are no special restrictions with regard to the average dimensions of the particles of component (IV), but from the viewpoint of improved moldability, the particles should be in the range of 0.1 to 50 µm. Two or more types of inorganic fillers having different average dimensions can be used in combination.

In order to improve affinity to component (I), component (IV) can be subjected to surface treatment with a silane coupling agent, a titanate coupling agent, or another similar coupling agent. Such silane coupling agents can be represented by 3-glycidoxypropyl trimethoxysilane, 3-glycidoxypropyl methyldiethoxysilane, 2-(3,4-epoxycyclohexyl) ethyltrimethoxysilane, or a similar epoxy-containing alkoxysilane; N-(2-aminoethyl)-3-aminopropyl trimethoxysilane, 3-aminopropyl triethoxysilane, N-phenyl-3-aminopropyl trimethoxysilane, or a similar amine-containing alkoxysilane; 3-mercaptopropyl trimethoxysilane or a similar mercapto-containing alkoxysilane; as well as 3-isocyanatepropyl triethoxysilane, or 3-ureidopropyl trimethoxysilane. And such titanate coupling agent can be represented by titanium tris(isostearate) i-propoxide. These coupling agents can be used in combination of two or more. There are no special restrictions with regard to the amounts in which the aforementioned coupling agents can be used. There are no restrictions also with regard to the methods of surface treatment.

Component (IV) should be used in the amount of at least 20 wt.%, preferably at least 30 wt.%, more preferably at least 50 wt.%, and most preferably at least 80 wt.% of the weight of the composition. If component (IV) is used in the amount less than the recommended lower limit, it will be difficult to impart sufficient strength to the cured body of the composition.

In the composition of the invention, component (IV) can be dispersed either in component (I) or in component (II). In order to improve affinity of component (IV) to component (I) or (II), a coupling agent, such as a silane coupling agent or a titanate coupling agent can be added to the mixture. These coupling agents can be exemplified by the same compounds as mentioned above.

The composition of the invention may additionally contain a curing accelerator (V). Such component (V) may be represented by triphenylphosphine, tributylphosphine, tri(p-methylphenyl) phosphine, tri(nonylphenyl) phosphine, triphenylphosphine-triphenylborate, tetraphenylphosphine-tetraphenylborate, or similar phosphorous compounds; triethylamine, benzyldimethylamine, α-methylbenzyldimethylamine, 1,8-diazobicyclo [5.4.0] undecene-7, or similar tertiary amine compounds; 2-methylimidazole, 2-phenylimidazone, 2-phenyl-4-methylimidazole, or similar imidazole compounds.

There are no special restrictions with regard to the amount in which component (V) can be added to the composition, but in general it can be recommended that this component be contained in the range of 0.001 to 20 parts by weight per 100 parts by weight of component (I). If the content of component (V) is below the recommended lower limit, it will be difficult to accelerate the reaction between components (I) and (II). If, on the other hand, the content of component (V) exceeds the recommended upper limit, this will impair strength of the cured body.

If necessary, the composition can be further combined with a stress-reducing agent, such as thermoplastic resin, thermoplastic elastomer, organic synthetic rubber, silicone, etc.; wax such as carnauba wax, higher fatty acid, synthetic wax, etc.; a coloring agent such as carbon black; a halogen-trap agent, etc.

There are no restrictions for the method of preparation of the composition, and the composition can be prepared by merely uniformly mixing components (I) to (IV), if necessary, with an addition of the arbitrary components. Dispersion conditions of component (III) can be improved if component (III) is added to and mixed with a composition obtained by premixing components (I) and (II). Alternatively, components (II), (III), and arbitrary components can be added to and uniformly mixed with a premixture of components (I) and (IV). In this case, the process can be exemplified by a so-called integral-blend method in which a coupling agent is added to components (I) and (IV), or by a method of premixing component (I) with component (IV) surface treated with a coupling agent. Mixing can be carried out by means of a single-shaft-type or a two-shaft-type continuous mixer, a two-roll mill, a Ross® mixer, a kneader mixer, a Henschel mixer, or the like.

Since the composition of the invention possesses excellent moldability prior to curing, it is suitable for use as a sealing agent, paint, coating agent, filler, adhesive, or a similar agent for electric or electronic devices and can be processed by transfer molding, injection molding, potting, casting, powder coating, immersion coating, drop-wise application, etc., for forming a cured body of low modulus of elasticity and high strength.

### Examples

The curable epoxy resin composition of the invention will be further described in more detail with reference to Practical Examples. All values of viscosities used in the examples correspond to 25°C.

Characteristics of the curable epoxy resin compositions and cured bodies of the compositions were measured by the methods described below. The compositions were precured by transfer press-curing for two minutes at 175°C under pressure of 70 kgf/cm² and then post-cured for 5 hours at 180°C.

### [Moldability]

- Spiral flow: measured at 175°C and 70 kgf/cm² by the method prescribed by the EMMI standard.
- Mold contamination: after continuously molding 5 disks with a diameter of 50 mm and a thickness of 2 mm in a row, the tarnishing of the chrome-plated surface of the mold was observed visually, designating cases in which there was no mold contamination as [○], case in which there was a thin tarnishing layer on the surface of the mold, as [△], and cases in which there was contamination on the surface of the mold, as [X].

### [Mechanical Characteristics]

- Flexural modulus of elasticity: measured as specified by JIS K 6911.
- Flexural strength: measured as specified by JIS K 6911.

### [Practical Example 1]

A curable epoxy resin composition was prepared by melting and uniformly mixing the following components by means of a hot two-roll mill: 51 parts by weight of a biphenyl-aralkyl type epoxy resin (produced by Nippon Kayaku Co., Ltd. under the name NC-3000; epoxy equivalent = 275; softening point = 56°C); 39.0 parts by weight of a biphenyl-aralkyl type phenol resin (produced by Meiwa Plastic Industries Co., Ltd. under the name MEH7851M; phenolic hydroxyl group equivalent = 207; softening point = 80°C); 3.0 parts by weight of a dimethylpolysiloxane of the following formula:

A - CH₂CH₂ (CH₃)₂ SiO [(CH₃)₂ SiO]₉₇ Si(CH₃)₂ CH₂CH₂ - A

{where "A" is represented by the following formula:

[X(CH₃)₂ SiO_{1/2}]_{1.6} (SiO_{4/2})_{1.0}

(where "X" is composed of single bonds and 3-glycidoxypropyl groups; at least one "X" in one molecule is a single bond, and the remaining part of "X" consists of 3-glycidoxypropyl groups)}; 510 parts by weight of spherical amorphous silica with an average particle size equal to 14 µm (the product of Denki Kagaku Kogyo Co., Ltd. known under the name of FB-48X); 1.0 part by weight of triphenylphosphine; and 1.0 part by weight of carnauba wax. Characteristics of the aforementioned curable epoxy resin compositions and of the cured bodies were measured. The results of measurement are shown in Table 1.

### [Practical Example 2]

A curable epoxy resin composition was prepared by melting and uniformly mixing the following components by means of a hot two-roll mill: 51.1 parts by weight of a biphenyl-aralkyl type epoxy resin (produced by Nippon Kayaku Co., Ltd. under the name NC-3000; epoxy equivalent = 275; softening point = 56°C); 38.9 parts by weight of a biphenyl-aralkyl type phenol resin (produced by Meiwa Plastic Industries Co., Ltd. under the name MEH7851M; phenolic hydroxyl group equivalent = 207; softening point = 80°C); 3.0 parts by weight of a dimethylpolysiloxane of the following formula:

A - CH₂CH₂ (CH₃)₂ SiO [(CH₃)₂ SiO]₉₇ Si(CH₃)₂ CH₂CH₂ - A

{where "A" is represented by the following formula:

[X(CH₃)₂ SiO_{1/2}]_{1.6} (SiO₄/₂)_{1.0}

(where "X" is composed of single bonds, trimethoxysilylpropyl groups, and 3-glycidoxypropyl groups; at least one "X" in one molecule is a single bond, and the remaining part of "X" consists of trimethoxysilylpropyl groups and 3-glycidoxypropyl groups used in a mole ratio of 1 to 4)}; 510 parts by weight of spherical amorphous silica with an average particle size equal to 14 µm (the product of Denki Kagaku Kogyo Co., Ltd. known under the name of FB-48X); 1.0 part by weight of triphenylphosphine; and 1.0 part by weight of carnauba wax. Characteristics of the aforementioned curable epoxy resin compositions and of the cured bodies were measured. The results of measurement are shown in Table 1.

### [Practical Example 3]

A curable epoxy resin composition was prepared by melting and uniformly mixing the following components by means of a hot two-roll mill: 51.2 parts by weight of a biphenyl-aralkyl type epoxy resin (produced by Nippon Kayaku Co., Ltd. under the name NC-3000; epoxy equivalent = 275; softening point = 56°C); 38.8 parts by weight of a biphenyl-aralkyl type phenol resin (produced by Meiwa Plastic Industries Co., Ltd. under the name MEH7851M; phenolic hydroxyl group equivalent = 207; softening point = 80°C); 3.0 parts by weight of a dimethylpolysiloxane of the following formula:

A - CH₂CH₂ (CH₃)₂ SiO [(CH₃)₂ SiO]₁₆₂ Si(CH₃)₂ CH₂CH₂ - A

{where "A" is represented by the following formula:

[X(CH₃)₂ SiO_{1/2}]_{1.6} (SiO_{4/2})_{1.0}

(where "X" is composed of single bonds, trimethoxysilylpropyl groups, and 3-glycidoxypropyl groups; at least one "X" in one molecule is a single bond, and the remaining part of "X" consists of trimethoxysilylpropyl groups and 3-glycidoxypropyl groups used in a mole ratio of 1 to 4)}; 510 parts by weight of spherical amorphous silica with an average particle size equal to 14 µm (the product of Denki Kagaku Kogyo Co., Ltd. known under the name of FB-48X); 1.0 part by weight of triphenylphosphine; and 1.0 part by weight of carnauba wax. Characteristics of the aforementioned curable epoxy resin compositions and of the cured bodies were measured. The results of measurement are shown in Table 1.

### [Practical Example 4]

A curable epoxy resin composition was prepared by melting and uniformly mixing the following components by means of a hot two-roll mill: 50.3 parts by weight of a biphenyl-aralkyl type epoxy resin (produced by Nippon Kayaku Co., Ltd. under the name NC-3000; epoxy equivalent = 275; softening point = 56°C); 39.7 parts by weight of a biphenyl-aralkyl type phenol resin (produced by Meiwa Plastic Industries Co., Ltd. under the name MEH7851 M; phenolic hydroxyl group equivalent = 207; softening point = 80°C); 3.0 parts by weight of a dimethylpolysiloxane of the following formula:

A - CH₂CH₂ (CH₃)₂ SiO [(CH₃)₂ SiO]₁₆₂ Si(CH₃)₂ CH₂CH₂ - A

{where A is represented by the following formula:

[X(CH₃)₂ SiO_{1/2}]_{0.8} [(CH₃)₃ SiO_{1/2}]_{0.8} (SiO_{4/2})_{1.0}

(where X is composed of single bonds, octyl groups, and glycidoxypropyl groups; at least one X in one molecule is a single bond, and the remaining part of X consists of octyl groups and 3-glycidoxypropyl groups used in a mole ratio of 1 to 4)}; 510 parts by weight of spherical amorphous silica with an average particle size equal to 14 µm (the product of Denki Kagaku Kogyo Co., Ltd. known under the name of FB-48X); 1.0 part by weight of triphenylphosphine; and 1.0 part by weight of carnauba wax. Characteristics of the aforementioned curable epoxy resin compositions and of the cured bodies were measured. The results of measurement are shown in Table 1.

### [Comparative Example 1]

A curable epoxy resin composition was prepared by melting and uniformly mixing the following components by means of a hot two-roll mill: 51.5 parts by weight of a biphenyl-aralkyl type epoxy resin (produced by Nippon Kayaku Co., Ltd. under the name NC-3000; epoxy equivalent = 275; softening point = 56°C); 38.5 parts by weight of a biphenyl-aralkyl type phenol resin (produced by Meiwa Plastic Industries Co., Ltd. under the name MEH7851M; phenolic hydroxyl group equivalent = 207; softening point = 80°C); 510 parts by weight of spherical amorphous silica with an average particle size equal to 14 µm (the product of Denki Kagaku Kogyo Co., Ltd. known under the name of FB-48X); 1.0 part by weight of triphenylphosphine; and 1.0 part by weight of carnauba wax. Characteristics of the aforementioned curable epoxy resin compositions and of the cured bodies were measured. The results of measurement are shown in Table 1.

### [Comparative Example 2]

A curable epoxy resin composition was prepared by melting and uniformly mixing the following components by means of a hot two-roll mill: 41.5 parts by weight of a biphenyl-aralkyl type epoxy resin (produced by Nippon Kayaku Co., Ltd. under the name NC-3000; epoxy equivalent = 275; softening point = 56°C); 38.5 parts by weight of a biphenyl-aralkyl type phenol resin (produced by Meiwa Plastic Industries Co., Ltd. under the name MEH7851 M; phenolic hydroxyl group equivalent = 207; softening point = 80°C); 3.0 parts by weight of a diorganopolysiloxane of the following formula:

(CH₃)₃ SiO [(CH₃)₂ SiO]₁₃₀ [Z(CH₃)SiO]₃ [CH₃ CO{OCH(CH₃)CH₂}₂₄ (OCH₂CH₂)₂₄ OCH₂CH₂CH₂(CH₃)SiO]₇ Si(CH₃)₃

(where "Z" is a 3-glycidoxypropyl group); 510 parts by weight of spherical amorphous silica with an average particle size equal to 14 µm (the product of Denki Kagaku Kogyo Co., Ltd. known under the name of FB-48X); 1.0 part by weight of triphenylphosphine; and 1.0 part by weight of carnauba wax. Characteristics of the aforementioned curable epoxy resin compositions and of the cured bodies were measured. The results of measurement are shown in Table 1.

[Table 1]

| Examples | Practical Examples | | | | Comp. Ex. | |
|---|---|---|---|---|---|---|
| Characteristics | 1 | 2 | 3 | 4 | 1 | 2 |
| Spiral flow (inch) | 17 | 17 | 17 | 22 | 25 | 23 |
| Mold contamination | ○ | ○ | ○ | ○ | ○ | x |
| Flexural modulus of elasticity (kgf/mm²) | 2260 | 2160 | 2240 | 2180 | 2380 | 2320 |
| Flexural strength (kgf/mm²) | 13.1 | 13.0 | 13.0 | 13.0 | 11.9 | 10.7 |

### Industrial Applicability

Since the curable epoxy resin composition is characterized by excellent moldability prior to curing, and, when cured, forms a cured body which, in spite of low modulus of elasticity (low stress), has high strength, it is suitable for use as a sealing agent for semiconductor devices.

## Claims

1. A curable epoxy resin composition comprising at least the following components:
(I) an epoxy resin;
(II) a curing agent for an epoxy resin;
(III) a diorganosiloxane that is used in an amount of 0.1 to 100 parts by weight per 100 parts by weight of the sum of components (I) and (II) and is represented by the following general formula:
A-R²-(R¹₂SiO)ₙ R¹₂Si-R²-A
{where R¹ designates the same or different unsubstituted or substituted monovalent hydrocarbon groups which are free of unsaturated aliphatic bonds; R² designates a bivalent organic group; "A" designates a siloxane residual radical represented by the following average unit formula:
(XR¹₂SiO_{1/2})ₐ (SiO_{4/2})_{b}
(where R¹ is the same as defined above, and "X" is a single bond, a hydrogen atom, a group designated by R¹, an epoxy-containing monovalent organic group, or an alkoxysilylalkyl group; however, in one molecule at least one group designated by "X" is a single bond, which is used for bonding to R² in the diorganosiloxane, at least two groups designated by "X" are epoxy-containing alkyl groups; "a" is a positive number; "b" is a positive number; and "a/b" is a number ranging from 0.2 to 4), and where "n" is an integer equal to or greater than 1}, and
(IV) an inorganic filler (contained in the composition in the amount of at least 20 wt.%).

2. The curable epoxy resin composition of Claim 1, wherein component (I) is an epoxy resin that contains biphenyl groups.

3. The curable epoxy resin composition of Claim 1, wherein component (II) is a compound that contains phenolic hydroxy groups.

4. The curable epoxy resin composition of Claim 3, wherein the compound that contains phenolic hydroxyl groups is a biphenyl-cantaining phenol resin.

5. The curable epoxy resin composition of Claim 1, wherein component (II) is contained in such an amount that the content of epoxy reactive functional groups in component (II) is in the range of 0.5 to 2.5 moles per 1 mole of the epoxy groups of component (I).

6. The curable epoxy resin composition of Claim 1, wherein in component (III) at least one group designated by "X" is a monovalent hydrocarbon group having six or more carbon atoms.

7. The curable epoxy resin composition of Claim 1, wherein in component (III) at least one group designated by "X" is an alkoxysilylalkyl group.

8. The curable epoxy resin composition of Claim 1, wherein component (IV) is a spherical inorganic filler.

9. The curable epoxy resin composition of Claim 1, wherein component (IV) is a spherical amorphous silica.

10. The curable epoxy resin composition of Claim 1, further provided with (V) a curing accelerator for an epoxy resin.

11. The curable epoxy resin composition according to any claim from 1 to 10, wherein the curable epoxy resin composition is a sealing agent for a semiconductor device.

12. A cured body obtained by curing the curable epoxy resin composition according to any claim from 1 to 10.

## Patentansprüche

1. Härtbare Epoxyharzzusammensetzung, die mindestens die folgenden Komponenten enthält:
(I) ein Epoxyharz;
(II) ein Härtungsmittel für ein Epoxyharz;
(III) ein Diorganosiloxan, das in einer Menge von 0,1 bis 100 Gewichtsteilen pro 100 Gewichtsteile der Summe der Komponenten (I) und (II) verwendet wird und durch die folgende allgemeine Formel wiedergegeben ist:
A-R²-(R¹₂SiO)ₙR¹₂Si-R²-A
{worin R¹ die gleichen oder unterschiedliche unsubstituierte oder substituierte monovalente Kohlenwasserstoffgruppen, die frei von ungesättigten aliphatischen Bindungen sind, bezeichnet; R² eine divalente organische Gruppe bezeichnet; "A" einen Siloxanrest bezeichnet, der durch die folgende mittlere Einheitsformel wiedergegeben ist:
(XR¹₂SiO_{1/2})ₐ(SiO_{4/2})_{b}
(worin R¹ wie oben definiert ist und "X" eine Einfachbindung, ein Wasserstoffatom, eine Gruppe, die durch R¹ bezeichnet wird, eine epoxyhaltige monovalente organische Gruppe oder eine Alkoxysilylalkylgruppe ist; wobei jedoch in einem Molekül mindestens eine Gruppe, die durch "X" bezeichnet wird, eine Einfachbindung ist, die verwendet wird, um an R² in dem Diorganosiloxan zu binden, und wobei mindestens zwei Gruppen, die als "X" bezeichnet werden, epoxyhaltige Alkylgruppen sind; "a" eine positive Zahl ist; "b" eine positive Zahl ist und "a/b" eine Zahl im Bereich von 0,2 bis 4 ist) und worin "n" eine ganze Zahl kleiner gleich oder größer als 1 ist} und
(IV) einen anorganischen Füllstoff (der in der Zusammensetzung in einer Menge von mindestens 20 Gew.-% vorhanden ist).

2. Härtbare Epoxyharzzusammensetzung nach Anspruch 1, wobei Komponente (I) ein Epoxyharz ist, das Biphenylgruppen enthält.

3. Härtbare Epoxyharzzusammensetzung nach Anspruch 1, wobei Komponente (II) eine Verbindung ist, die phenolische Hydroxylgruppen enthält.

4. Härtbare Epoxyharzzusammensetzung nach Anspruch 3, wobei die Verbindung, die phenolische Hydroxylgruppen enthält, ein biphenylhaltiges Phenolharz ist.

5. Härtbare Epoxyharzzusammensetzung nach Anspruch 1, wobei Komponente (II) in solch einer Menge vorhanden ist, dass der Gehalt an mit Epoxy reaktiven funktionellen Gruppen in Komponente (II) im Bereich von 0,5 bis 2,5 mol pro 1 mol der Epoxygruppen aus Komponente (I) liegt.

6. Härtbare Epoxyharzzusammensetzung nach Anspruch 1, wobei in Komponente (III) mindestens eine Gruppe, die mit "X" bezeichnet wird, eine monovalente Kohlenwasserstoffgruppe mit sechs oder mehr Kohlenstoffatomen ist.

7. Härtbare Epoxyharzzusammensetzung nach Anspruch 1, wobei in Komponente (III) mindestens eine Gruppe, die mit "X" bezeichnet wird, eine Alkoxysilylalkylgruppe ist.

8. Härtbare Epoxyharzzusammensetzung nach Anspruch 1, wobei Komponente (IV) ein kugelförmiger anorganischer Füllstoff ist.

9. Härtbare Epoxyharzzusammensetzung nach Anspruch 1, wobei Komponente (IV) ein kugelförmiges amorphes Siliciumdioxid ist.

10. Härtbare Epoxyharzzusammensetzung nach Anspruch 1, die ferner mit (V) einem Härtungsbeschleuniger für ein Epoxyharz ausgestattet ist.

11. Härtbare Epoxyharzzusammensetzung nach einem der Ansprüche 1 bis 10, wobei die härtbare Epoxyharzzusammensetzung ein Versiegelungsmittel für ein Halbleiterbauteil ist.

12. Gehärteter Körper, der durch Härten der härtbaren Epoxyharzzusammensetzung nach einem der Ansprüche 1 bis 10 erhalten wird.

## Revendications

1. Composition de résine époxy durcissable comprenant au moins les composants suivants :
(I) une résine époxy ;
(II) un agent durcisseur pour une résine époxy ;
(III) un diorganosiloxane qui est utilisé dans une quantité de 0,1 à 100 parties en poids pour 100 parties en poids de la somme des composants (I) et (II) et est représenté par la formule générale suivante :
A-R²-(R¹₂SiO)ₙR¹₂Si-R²-A
{où R¹ désigne des groupes hydrocarbures monovalents non substitués ou substitués identiques ou différents qui sont exempts de liaisons aliphatiques insaturées ; R² désigne un groupe organique bivalent ; « A » désigne un radical résiduel siloxane représenté par la formule unitaire moyenne suivante :
(XR¹₂SiO_{1/2})ₐ(SiO_{4/2})_{b}
(où R¹ est tel que défini ci-dessus, et « X » est une liaison unique, un atome d'hydrogène, un groupe désigné par R¹, un groupe organique monovalent contenant de l'époxy, ou un groupe alkoxysilylalkyle ; toutefois, dans une molécule au moins un groupe désigné par « X » est une liaison unique, qui est utilisée pour se lier à R² dans le diorganosiloxane, au moins deux groupes désignés par « X » sont des groupes alkyles contenant de l'époxy ; « a » est un nombre positif ; « b » est un nombre positif ; et « a/b » est un nombre allant de 0,2 à 4), et où « n » est un entier égal ou supérieur à 1}, et
(IV) une charge minérale (contenue dans la composition dans la quantité d'au moins 20 % en poids).

2. Composition de résine époxy durcissable selon la revendication 1, dans laquelle le composant (I) est une résine époxy qui contient des groupes biphényles.

3. Composition de résine époxy durcissable selon la revendication 1, dans laquelle le composant (II) est un composé qui contient des groupes hydroxyles phénoliques.

4. Composition de résine époxy durcissable selon la revendication 3, dans laquelle le composé qui contient des groupes hydroxyles phénoliques est une résine phénol contenant du biphényle.

5. Composition de résine époxy durcissable selon la revendication 1, dans laquelle le composant (II) est contenu dans une telle quantité que la teneur en groupes fonctionnels réactifs à l'époxy dans le composant (II) est dans la gamme de 0,5 à 2,5 moles pour 1 mole des groupes époxy du composant (I).

6. Composition de résine époxy durcissable selon la revendication 1, dans laquelle dans le composant (III) au moins un groupe désigné par « X » est un groupe hydrocarbure monovalent ayant au moins six atomes de carbone.

7. Composition de résine époxy durcissable selon la revendication 1, dans laquelle dans le composant (III) au moins un groupe désigné par « X » est un groupe alkoxysilylalkyle.

8. Composition de résine époxy durcissable selon la revendication 1, dans laquelle le composant (IV) est une charge minérale sphérique.

9. Composition de résine époxy durcissable selon la revendication 1, dans laquelle le composant (IV) est une silice amorphe sphérique.

10. Composition de résine époxy durcissable selon la revendication 1, fournie en outre avec le composant (V), un accélérateur de durcissement pour une résine époxy.

11. Composition de résine époxy durcissable selon l'une quelconque des revendications 1 à 10, dans laquelle la composition de résine époxy durcissable est un agent d'étanchéité pour un dispositif à semiconducteurs.

12. Corps durci obtenu en durcissant la composition de résine époxy durcissable selon l'une quelconque des revendications 1 à 10.
